(19) Europäisches Patentamt
European Patent Office
Office européen des brevets

(11) **EP 4 207 270 A1**

(12) **EUROPEAN PATENT APPLICATION**
published in accordance with Art. 153(4) EPC

(43) Date of publication:
**05.07.2023 Bulletin 2023/27**

(21) Application number: **21906033.2**

(22) Date of filing: **01.07.2021**

(51) International Patent Classification (IPC):
**H01L 23/36** (2006.01)    **C08L 83/04** (2006.01)
**C08K 3/01** (2018.01)

(52) Cooperative Patent Classification (CPC):
**C08K 3/01; C08L 83/04; H01L 23/36**

(86) International application number:
**PCT/JP2021/025007**

(87) International publication number:
**WO 2022/130666 (23.06.2022 Gazette 2022/25)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **16.12.2020 JP 2020208575**

(71) Applicant: **Fuji Polymer Industries Co., Ltd.
Nagoya-shi, Aichi 4500002 (JP)**

(72) Inventor: **SUZUMURA Katsuyuki
Aichi 463-0026 (JP)**

(74) Representative: **Dehns
St. Bride's House
10 Salisbury Square
London EC4Y 8JD (GB)**

(54) **THERMALLY CONDUCTIVE SHEET AND METHOD FOR MANUFACTURING SAME**

(57)    The present invention relates to a thermally conductive sheet 12 containing a matrix resin (A) and thermally conductive inorganic particles (B). The matrix resin (A) contains an addition-curable silicone polymer (A1) and a non-reactive silicone oil (A2), the addition-curable silicone polymer (A1) accounting for 20% by mass or more and less than 100% by mass and the non-reactive silicone oil (A2) accounting for more than 0% by mass and 80% by mass or less relative to 100% by mass of the matrix resin (A). The thermally conductive sheet contains the thermally conductive inorganic particles (B) in an amount of 1000 to 3000 parts by mass relative to 100 parts by mass of the matrix resin (A). The thermally conductive sheet 12 is a cured sheet. 16 indicates an oil bleeding region. The present invention provides a thermally conductive sheet with reduced oil bleeding, and a method for producing the same.

FIG. 2A

FIG. 2B

**Description**

Technical Field

The present invention relates to a thermally conductive sheet that is suitable to be interposed between a heat generating member and a heat dissipating material of electrical and electronic components or the like, and a method for producing the same.

Background Art

With the significant improvement in performance of semiconductors such as CPUs in recent years, the amount of heat generated by them has become extremely large. For this reason, heat dissipating materials are attached to electronic components that may generate heat, and a thermally conductive silicone gel is used to improve the adhesion between the semiconductors and the heat dissipating materials. A conventional thermally conductive silicone gel composition can be in the form of a gel cured product by containing an alkenyl group and a Si-H group in different proportions to leave an unreacted portion. However, due to the different proportions of the alkenyl group and the Si-H group, the unreacted oil of the material remains in the gel cured product, which may lead to oil bleeding.

Patent Document 1 proposes a heat dissipating member including the following: an organopolysiloxane having one or more alkenyl groups bonded to silicon atoms per molecule; an organohydrogenpolysiloxane having two or more hydrogen atoms bonded to silicon atoms per molecule; a platinum-based catalyst; and thermally conductive particles, and claim 3 recites the use of an organohydrogenpolysiloxane containing many Si-H groups. Patent Document 2 proposes, to produce a gel with less oil bleeding, a heat-dissipating silicone gel composition including the following: an alkenyl group-containing polyorganosiloxane with a specific viscosity having about two alkenyl groups on average that are bonded to silicon atoms per molecule, the other organic groups that are bonded to the silicon atoms being substituted or unsubstituted monovalent hydrocarbon groups not containing an aliphatic unsaturated bond; and a diorganohydrogensiloxy-terminated polyorganosiloxane. Patent Document 3 proposes subjecting thermally conductive particles to a surface treatment.

Prior Art Documents

Patent Documents

   Patent Document 1: JP 2005-344106 A
   Patent Document 2: JP 2008-143980 A
   Patent Document 3: JP 2020-002236 A

Disclosure of Invention

Problem to be Solved by the Invention

However, conventional thermally conductive silicone compositions are low in the thermal conductivity.

With the foregoing in mind, the present invention provides a thermally conductive sheet having high thermal conductivity with reduced oil bleeding, and a method for producing the same.

Means for Solving Problem

A thermally conductive sheet of the present invention is a thermally conductive sheet containing a matrix resin (A) and thermally conductive inorganic particles (B). The matrix resin (A) contains an addition-curable silicone polymer (A1) and a non-reactive silicone oil (A2), the addition-curable silicone polymer (A1) accounting for 20% by mass or more and less than 100% by mass and the non-reactive silicone oil (A2) accounting for more than 0% by mass and 80% by mass or less relative to 100% by mass of the matrix resin (A). The thermally conductive sheet contains the thermally conductive inorganic particles (B) in an amount of 1000 to 3000 parts by mass relative to 100 parts by mass of the matrix resin (A). The thermally conductive sheet is a cured sheet.

A method for producing the thermally conductive sheet of the present invention is a method for producing a thermally conductive sheet containing an addition-curable silicone polymer (A1), a non-reactive silicone oil (A2), and thermally conductive inorganic particles. The matrix resin (A) contains the addition-curable silicone polymer (A1) and the non-reactive silicone oil (A2), the addition-curable silicone polymer (A1) accounting for 20% by mass or more and less than 100% by mass and the non-reactive silicone oil (A2) accounting for more than 0% by mass and 80% by mass or less relative to 100% by mass of the matrix resin (A). The thermally conductive sheet contains the thermally conductive inorganic particles (B) in an amount of 1000 to 3000 parts by mass relative to 100 parts by mass of the matrix resin (A). The method includes preparing a mixture containing the addition-curable silicone polymer (A1), the non-reactive silicone oil (A2), and the thermally conductive inorganic particles (B), sheeting the mixture, and curing the sheet.

Effect of the Invention

A thermally conductive sheet of the present invention is a thermally conductive sheet containing a matrix resin (A) and thermally conductive inorganic particles (B). The matrix resin (A) contains an addition-curable silicone polymer (A1) and a non-reactive silicone oil (A2), the addition-curable silicone polymer (A1) accounting for 20% by mass or more and less than 100% by mass and the non-reactive silicone oil (A2) accounting for more than 0% by mass and 80% by mass or less relative to 100% by mass of the matrix resin (A). The thermally conductive sheet contains the thermally conductive inorganic particles (B) in an amount of 1000 to 3000 parts by mass relative to 100 parts by mass of the matrix resin (A), and the thermally conductive sheet is a cured sheet. With the above configurations, the present invention can provide a thermally conductive sheet having high thermal conductivity with reduced oil bleeding, and a method for producing the same. Further, the present invention can provide a thermally conductive silicone composition with reduced oil bleeding by partially replacing the addition-curable silicone polymer (A1) with the non-reactive silicone oil (A2). Moreover, such a combined use of the addition-curable silicone polymer (A1) and the non-reactive silicone oil (A2) can lower the crosslinking density as compared with the case of using the addition-curable silicone polymer alone, thereby achieving a low compressive load.

Brief Description of Drawings

[FIG. 1] FIGS. 1A and 1B are diagrams illustrating a method for measuring the thermal conductivity of a sample in an example of the present invention.
[FIG. 2] FIG. 2A is a schematic cross-sectional view illustrating a measurement test of an oil bleeding width in one example of the present invention, and FIG. 2B is a schematic plan view illustrating the measurement of the oil bleeding width.

Description of the Invention

The present invention relates to a thermally conductive sheet containing a matrix resin (A) and thermally conductive inorganic particles (B). The matrix resin (A) contains an addition-curable silicone polymer (A1) and a non-reactive silicone oil (A2). The addition-curable silicone polymer (A1) accounts for 20% by mass or more and less than 100% by mass and the non-reactive silicone oil (A2) accounts for more than 0% by mass and 80% by mass or less relative to 100% by mass of the matrix resin (A), and preferably the addition-curable silicone polymer (A1) accounts for 30% by mass or more and 90% by mass or less and the non-reactive silicone oil (A2) accounts for 10% by mass or more and 70% by mass or less. Within the above range, oil bleeding can be minimized.

The thermally conductive sheet contains the thermally conductive inorganic particles (B) in an amount of 1000 to 3000 parts by mass and preferably in an amount of 1500 to 2200 parts by mass relative to 100 parts by mass of the matrix resin (A). Within the above range, high thermal conductivity can be obtained.

The non-reactive silicone oil (A2) has a viscosity of preferably 50 to 3000 mm$^2$/s, and more preferably 70 to 2500 mm$^2$/s at 25°C. A Brookfield rotational viscometer Sp No. 2 is used to measure the viscosity. Within the above range of the viscosity, oil bleeding can be minimized while improving the filling property of the thermally conductive inorganic particles. The non-reactive silicone oil is a silicone polymer having no reaction groups, and examples thereof include dimethylpolysiloxane and diphenylpolysiloxane.

The thermally conductive sheet has a thermal conductivity of preferably 5.0 to 15.0 W/mK, more preferably 6.0 to 15.0 W/mK, and further preferably 7.0 to 15.0 W/mK. Within the above range of the thermal conductivity, the sheet can be applied in a variety of devices.

The thermally conductive sheet has an oil bleeding width of preferably 9.5 mm or less, where the oil bleeding width is a width of oil bleeding determined by sandwiching the thermally conductive sheet of 25 mm in length, 25 mm in width, and 1 mm in thickness between a glass plate and powder paper and compressing it at a compression ratio of 50% at 125°C for 72 hours. The oil bleeding width is more preferably 3 mm or less. Thus, oil bleeding is minimized.

The thermally conductive sheet of the present invention has a 50% compressive load value of preferably 1000 N or less, and more preferably 600 N or less. Thus, the thermally conductive sheet deforms easily, which is advantageous in reducing the physical load to be applied on a heat generating member.

The following describes the production method for the thermally conductive sheet of the present invention.

(1) As the matrix resin (A), the addition-curable silicone polymer (A1) and the non-reactive silicone oil (A2) are prepared, the addition-curable silicone polymer (A1) accounting for 20% by mass or more and less than 100% by mass and the non-reactive silicone oil (A2) accounting for more than 0% by mass and 80% by mass or less relative to 100% by mass of the matrix resin (A). The amount of the thermally conductive inorganic particles (B) is 1000 to 3000 parts by mass relative to 100 parts by mass of the matrix resin (A).

As the addition-curable silicone polymer (A1), it is preferable to use an addition-curable silicone polymer (A1) that yields an oil bleeding width of 1.5 mm or less when a composition containing the addition-curable silicone polymer (A1) and the thermally conductive inorganic particles, in amounts of 100 parts by mass and 1000 to 3000 parts by mass, respectively, is formed into a sheet of 25 mm in length, 25 mm in width, and 1 mm in thickness, and the cured sheet is sandwiched between a glass plate and powder paper and compressed at a compression ratio of 50% at 125°C for 72 hours. By doing so, the oil bleeding width of the thermally conductive sheet can be reduced. Hereinafter, the oil bleeding width of the cured sheet of the composition containing the addition-curable silicone polymer and the thermally conductive inorganic particles as materials is referred to as an oil bleeding width of the cured sheet of the base polymer composition.

(2) A mixture containing the addition-curable silicone polymer (A1), the non-reactive silicone oil (A2), and the thermally conductive inorganic particles (B) is prepared, which is then formed into a sheet and cured. A mixing device such as a kneader, a homogenizer, a planetary mixer, or a dissolver is preferably used for mixing. The mixture is preferably defoamed under reduced pressure during or after mixing. The mixture is formed into a sheet with a predetermined thickness by rolling, press forming, or the like. The sheet may be cured at room temperature or cured with heat. In the case of heat curing, the sheet is heated at 80 to 120°C for 5 to 40 minutes.

The thermally conductive inorganic particles are preferably inorganic particles of at least one selected from the group consisting of alumina (aluminum oxide), zinc oxide, silicon oxide, silicon carbide, aluminum nitride, boron nitride, aluminum hydroxide, and silica. Among these, alumina (aluminum oxide) and aluminum nitride are particularly preferred. The shape of the thermally conductive inorganic particles may be, but is not particularly limited to, spherical, amorphous, needle-like, or plate-like.

Examples of the aluminum oxide include, but are not particularly limited to, spherical alumina produced by heat melting, sintered alumina produced by firing in a kiln, electrofused alumina produced by melting in an electric arc furnace, and high purity alumina produced by hydrolysis, in-situ chemical vapor deposition or the like of aluminum alkoxide. The obtained aluminum oxide particles may be formed into a particle size of a target range by pulverization, for example. Thus, crushed aluminum oxide particles are obtained. In the present invention, crushed aluminum oxide particles are preferably used.

Examples of the aluminum nitride include, but are not particularly limited to, aluminum nitride produced by direct nitriding, reduction nitriding, combustion synthesis or the like, and coagulated aluminum nitride produced by coagulating the obtained aluminum nitride. The obtained aluminum nitride particles may be formed into a particle size of a target range by pulverization, for example. Thus, crushed aluminum nitride particles are obtained. In the present invention, crushed aluminum nitride particles are preferably used.

The thermally conductive inorganic particles have an average particle size of preferably 0.01 $\mu$m or more and 200 pm or less, and more preferably 0.1 pm or more and 150 $\mu$m or less. The average particle size refers to D50 (median diameter) in a volume-based cumulative particle size distribution, which is determined in a particle size distribution measurement according to a laser diffracted light scattering method.

As the matrix resin, an addition-curable silicone polymer (organopolysiloxane) is used. The polymer has high heat resistance and useful as a thermally conductive sheet. The organopolysiloxane may be a commercially available organopolysiloxane, and the viscosity is preferably 100 to 10000 mPa·s. The addition-curable silicone polymer (organopolysiloxane) cures by an addition reaction using a platinum-based curing catalyst. The addition-curable silicone polymer (organopolysiloxane) typically includes a solution A and a solution B, one solution containing a platinum-based curing catalyst and the other solution containing a vulcanizing agent (curing agent). These solutions are mixed to form a composition, which is then formed into a sheet and cured.

The thermally conductive sheet may further contain a silane coupling agent in an amount of more than 0 parts by mass and 200 parts by mass with respect to 100 parts by mass of the matrix resin. The silane coupling agent may be a silane compound expressed by $R\text{-}Si(CH_3)_a(OR')_{3-a}$ or its partial hydrolysate, where R represents a substituted or unsubstituted organic group having 1 to 20 carbon atoms, R' represents an alkyl group having 1 to 4 carbon atoms, and a is 0 or 1. Examples of the alkoxysilane compound expressed by the above chemical formula (hereinafter simply referred to as "silane") include the following: methyltrimethoxysilane; ethyltrimethoxysilane; propyltrimethoxysilane; butyltrimethoxysilane; pentyltrimethoxysilane; hexyltrimethoxysilane; hexyltriethoxysilane; octyltrimethoxysilane; octyltriethoxysilane; decyltrimethoxysilane; decyltriethoxysilane; dodecyltrimethoxysilane; dodecyltriethoxysilane; hexadecyltrimethoxysilane; hexadodecyltriethoxysilane; octadecyltrimethoxysilane; and octadecyltriethoxysilane. These silane compounds may be used individually or in combinations of two or more. The silane coupling agent may be used as a surface treatment agent of the thermally conductive inorganic particles.

The thermally conductive sheet of the present invention may contain components other than the above as needed. For example, a heat resistance improver such as colcothar, titanium oxide or cerium oxide, a flame retardant aid, and a curing retarder may be added. For coloring and toning, an organic or inorganic pigment may be added. The above silane coupling agent may be added.

Examples

Hereinafter, the present invention will be described by way of examples. However, the present invention is not limited to the following examples. Various parameters were measured according to the methods described below.

<Thermal conductivity>

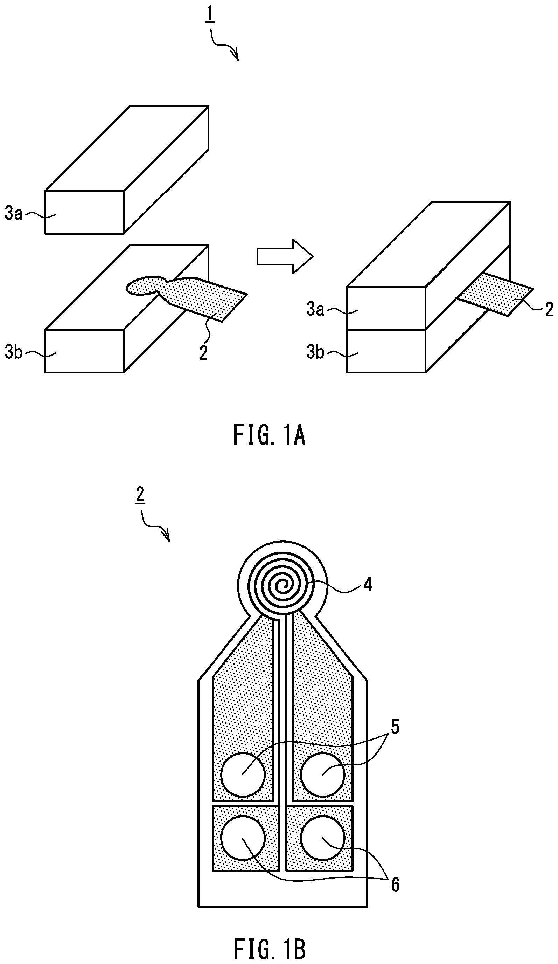

The thermal conductivity of thermally conductive grease was measured by a hot disk (according to ISO/CD 22007-2). As shown in FIG. 1A, in a thermal conductivity measuring apparatus 1, a polyimide film sensor 2 was sandwiched between two samples 3a, 3b, and constant power was applied to the sensor 2 to generate a certain amount of heat. Then, the thermal characteristics were analyzed from the value of a temperature rise of the sensor 2. The sensor 2 has a tip 4 with a diameter of 7 mm. As shown in FIG. 1B, the tip 4 has a double spiral structure of electrodes. An electrode 5 for an applied current and an electrode 6 for a resistance value (temperature measurement electrode) are located on the lower portion of the sensor 2. The thermal conductivity was calculated by the following formula (1).

[Formula 1]

$$\lambda = \frac{P_0 \cdot D(\tau)}{\pi^{3/2} \cdot r} \cdot \frac{D(\tau)}{\Delta T(\tau)}$$

$\lambda$:          Thermal conductivity (W/m·K)
$P_0$:          Constant power (W)
r:          Radius of sensor (m)
$\tau$:          $\sqrt{\alpha \cdot t / r^2}$
$\alpha$:          Thermal diffusivity of sample ($m^2$/s)
t:          Measuring time (s)
$D(\tau)$:          Dimensionless function of $\tau$
$\Delta T(\tau)$:          Temperature rise of sensor (K)

<Method for measuring oil bleeding width>

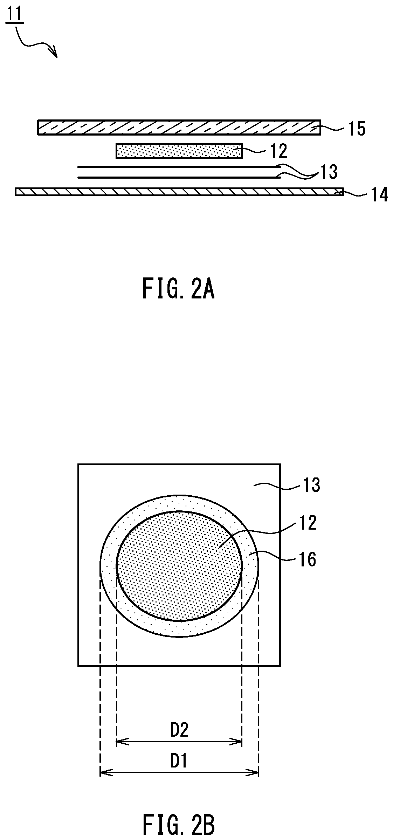

FIG. 2A is a schematic cross-sectional view illustrating a measurement tester 11 for measuring an oil bleeding width in one example of the present invention. A thermally conductive cured sheet sample 12 of 25 mm in length, 25 mm in width, and 1 mm in thickness is sandwiched between an upper glass plate 15 and two sheets of powder paper 13 that are placed on an aluminum plate 14, and compressed at a compression ratio of 50% at 125°C for 72 hours to measure an oil bleeding width (oil spread width) of the sample. FIG. 2B is a schematic plan view illustrating the measurement of the oil bleeding width (oil spread width) of the sample. The oil bleeding width is calculated from the formula below.

$$\text{Oil bleeding width} = (D1 - D2) / 2$$

Here, D2 represents a size of the thermally conductive cured sheet sample 12 on the powder paper 13 after compression, and D1 represents a length of an oil bleeding region 16 from one end to the other.

The unit is mm. The oil bleeding width of the cured sheet of the base polymer composition is measured in the same manner as described above.

<Viscosity of non-reactive silicone oil>

A Brookfield rotational viscometer Sp No. 2 was used to measure the viscosity at 25°C.

<50% Compressive load value>

Using a method according to ASTM D575-91:2012, a sample of φ (diameter) 28.6 mm × 1.0 mm was sandwiched between aluminum blocks of φ 28.6 mm × 4.0 mm. An instantaneous value when the sample was compressed to 50% was determined as a 50% compressive load value.

(Examples 1 to 4, Comparative Example 1)

(1) Material components

• Matrix resin (A)

As the addition-curable silicone polymer (A1), a commercially available two-part organopolysiloxane was used, one solution containing a platinum-based curing catalyst and the other solution containing a vulcanizing agent (curing agent).
As the non-reactive silicone oil (A2), a commercially available dimethyl silicone oil (viscosity, 100 $mm^2$/s) was used.

• Thermally conductive inorganic particles (B)

Aluminum nitride (average particle size, 70 pm, 20 pm, 1 pm, the shape of particles, crushed) and aluminum oxide (average particle size, 0.3 μm, the shape of particles, crushed) were added in a total amount of 1500 parts by mass relative to 100 parts by mass of the matrix resin (A). The aluminum oxide filler used was surface-treated (pretreated) with n-octyltriethoxysilane. The surface treatment was performed by adding 2.48 parts by mass of n-octyltriethoxysilane relative to 100 parts by mass of the aluminum oxide, followed by stirring and heat treatment for 12 hours at 125°C.

(2) Mixing

The material components were placed in a planetary mixer and mixed for 10 minutes at 23°C. The mixture was defoamed under reduced pressure during or after mixing.

(3) Formation of cured sheet

The thermally conductive composition thus mixed was formed into a sheet of 1 mm in thickness by rolling and cured with heat in an oven at 100°C for 20 minutes.
Table 1 summarizes various properties of the obtained cured sheets. In Table 1, "Oil bleeding width of base polymer composition" refers to the oil bleeding width of the cured sheet of the composition not containing the silicone oil. The oil bleeding width of the cured sheet of the composition containing the silicone oil simply refers to "Oil bleeding width". The same applies to Tables 2 to 4.

[Table 1]

|  | Ex. 1 | Ex. 2 | Ex. 3 | Ex. 4 | Comp. Ex. 1 |
|---|---|---|---|---|---|
| Oil bleeding width of base polymer composition (mm) | 0 | 0 | 0 | 0 | 0 |
| Addition-curable silicone polymer (A1) (mass%) | 70 | 50 | 30 | 20 | 10 |
| Non-reactive silicone oil (A2) (mass%) | 30 | 50 | 70 | 80 | 90 |

(continued)

|  | | Ex. 1 | Ex. 2 | Ex. 3 | Ex. 4 | Comp. Ex. 1 |
|---|---|---|---|---|---|---|
| Thermally conductive inorganic particles | Aluminum nitride (g) | 1320 | 1320 | 1320 | 1320 | 1320 |
| | Aluminum oxide (g) | 180 | 180 | 180 | 180 | 180 |
| | Total mass (g) | 1500 | 1500 | 1500 | 1500 | 1500 |
| 50% Compressive load value (N) | | 617 | 304 | 135 | 87 | 37 |
| Oil bleeding width (mm) | | 0.0 | 1.3 | 6.1 | 9.4 | 20.7 |
| Thermal conductivity (W/mK) | | 8 | 8 | 8 | 8 | 8 |
| * Ex.: Example, Comp. Ex.: Comparative Example | | | | | | |

As shown in Table 1, the sheets of Examples 1 to 4 had a narrower oil bleeding width than the sheet of Comparative Example 1.

(Examples 5 to 8, Comparative Examples 2 and 3)

Thermally conductive sheets of Examples 5 to 8 and Comparative Examples 2 and 3 were produced in the same manner as in Example 1 except that the total amount of the thermally conductive inorganic particles (B) relative to 100 parts by mass of the matrix resin (A) was changed to 2010 parts by mass, and the oil ratio was changed. Table 2 shows the conditions and results.

[Table 2]

|  | | Ex. 5 | Ex. 6 | Ex. 7 | Ex. 8 | Comp. Ex. 2 | Comp. Ex. 3 |
|---|---|---|---|---|---|---|---|
| Oil bleeding width of base polymer composition (mm) | | 0 | 0 | 0 | 0 | 0 | 0 |
| Addition-curable silicone polymer (A1) (mass%) | | 70 | 50 | 30 | 20 | 90 | 10 |
| Non-reactive silicone oil (A2) (mass%) | | 30 | 50 | 70 | 80 | 10 | 90 |
| Thermally conductive inorganic particles | Aluminum nitride (g) | 1770 | 1770 | 1770 | 1770 | 1770 | 1770 |
| | Aluminum oxide (g) | 240 | 240 | 240 | 240 | 240 | 240 |
| | Total mass (g) | 2010 | 2010 | 2010 | 2010 | 2010 | 2010 |
| 50% Compressive load value (N) | | 2293 | 1225 | 551 | 350 | 3544 | 194 |
| Oil bleeding width (mm) | | 0.0 | 0.0 | 0.0 | 0.8 | 0.0 | 10.2 |
| Thermal conductivity (W/mK) | | 11 | 11 | 11 | 11 | 11 | 11 |
| * Ex.: Example, Comp. Ex.: Comparative Example | | | | | | | |

As shown in Table 2, the sheets of Examples 5 to 8 had a narrower oil bleeding width than the sheet of Comparative Example 3. Moreover, the sheets of Examples 5 to 8 had a lower 50% compressive load value than the sheet of Comparative Example 2. This is because the crosslinking density was relatively lowered as compared with the case of using the addition-curable silicone polymer alone.

(Examples 9 to 11)

Thermally conductive sheets of Examples 9 to 11 were produced in the same manner as in Example 1 except that the total amount of the thermally conductive inorganic particles (B) relative to 100 parts by mass of the matrix resin (A) was changed to 2200 parts by mass, and the oil ratio was changed. Table 3 shows the conditions and results.

[Table 3]

|  |  | Ex. 9 | Ex. 10 | Ex. 11 |
|---|---|---|---|---|
| Oil bleeding width of base polymer (mm) |  | 0 | 0 | 0 |
| Addition-curable silicone polymer (A1) (mass%) |  | 40 | 30 | 20 |
| Non-reactive silicone oil (A2) (mass%) |  | 60 | 70 | 80 |
| Thermally conductive inorganic particles | Aluminum nitride (g) | 1935 | 1935 | 1935 |
|  | Aluminum oxide (g) | 265 | 265 | 265 |
|  | Total mass (g) | 2200 | 2200 | 2200 |
| 50% Compressive load value (N) |  | 696 | 585 | 409 |
| Oil bleeding width (mm) |  | 0.0 | 1.1 | 3.7 |
| Thermal conductivity (W/mK) |  | 13 | 13 | 13 |
| * Ex.: Example |  |  |  |  |

As shown in Table 3, the sheets of Examples 9 to 11 had a narrow oil bleeding width.

(Comparative Examples 4 to 9)

Thermally conductive sheets of Comparative Examples 4 to 9 were produced in the same manner as in Example 1 except that addition-curable silicone polymers (A1) yielding the oil bleeding width of the base polymer composition as indicated in Table 4 were used, and the oil ratio was changed. Table 4 shows the conditions and results.

[Table 4]

|  |  | Comp. Ex. 4 | Comp. Ex. 5 | Comp. Ex. 6 | Comp. Ex. 7 | Comp. Ex. 8 | Comp. Ex. 9 |
|---|---|---|---|---|---|---|---|
| Oil bleeding width of base polymer composition (mm) |  | 6.3 | 6.3 | 6.3 | 11.2 | 11.2 | 11.2 |
| Addition-curable silicone polymer (A1) (mass%) |  | 50 | 30 | 20 | 50 | 30 | 20 |
| Non-reactive silicone oil (A2) (mass%) |  | 50 | 70 | 80 | 50 | 70 | 80 |
| Thermally conductive inorganic particles | Aluminum nitride (g) | 1320 | 1320 | 1320 | 1320 | 1320 | 1320 |
|  | Aluminum oxide (g) | 180 | 180 | 180 | 180 | 180 | 180 |
|  | Total mass (g) | 1500 | 1500 | 1500 | 1500 | 1500 | 1500 |
| 50% Compressive load value (N) |  | 413 | 128 | 86 | 249 | 50 | 43 |
| Oil bleeding width (mm) |  | 9.8 | 15.1 | 17.4 | 9.8 | 13.7 | 22.2 |
| Thermal conductivity (W/mK) |  | 8 | 8 | 8 | 8 | 8 | 8 |
| * Comp. Ex.: Comparative Example |  |  |  |  |  |  |  |

As shown in Table 4, since the oil bleeding widths of the base polymer compositions of Comparative Examples 4 to 9 were wide, the oil bleeding widths of the thermally conductive cured sheets were also wide and unfavorable.

Industrial Applicability

The thermally conductive silicone sheet of the present invention is suitable to be interposed between a heat generating member and a heat dissipating material of electrical and electronic components or the like.

Description of Reference Numerals

1 Thermal conductivity measuring apparatus
2 Sensor
3a, 3b Sample
4 Tip of the sensor
5 Electrode for applied current
6 Electrode for resistance value (temperature measurement electrode)
11 Oil bleeding width measurement tester
12 Thermally conductive cured sheet sample
13 Powder paper
14 Aluminum plate
15 Glass plate
16 Oil bleeding region

**Claims**

1. A thermally conductive sheet, comprising:

   a matrix resin (A); and
   thermally conductive inorganic particles (B),
   wherein the matrix resin (A) comprises an addition-curable silicone polymer (A1) and a non-reactive silicone oil (A2), the addition-curable silicone polymer (A1) accounting for 20% by mass or more and less than 100% by mass and the non-reactive silicone oil (A2) accounting for more than 0% by mass and 80% by mass or less relative to 100% by mass of the matrix resin (A),
   the thermally conductive sheet comprises the thermally conductive inorganic particles (B) in an amount of 1000 to 3000 parts by mass relative to 100 parts by mass of the matrix resin (A), and
   the thermally conductive sheet is a cured sheet.

2. The thermally conductive sheet according to claim 1, wherein the non-reactive silicone oil (A2) has a viscosity of 50 to 3000 $mm^2$/s at 25°C.

3. The thermally conductive sheet according to claim 1 or 2, wherein the thermally conductive sheet has a thermal conductivity of 5.0 to 15.0 W/mK.

4. The thermally conductive sheet according to any one of claims 1 to 3, wherein the thermally conductive sheet has an oil bleeding width of 9.5 mm or less, where the oil bleeding width is a width of oil bleeding determined by sandwiching the thermally conductive sheet of 25 mm in length, 25 mm in width, and 1 mm in thickness between a glass plate and powder paper and compressing it at a compression ratio of 50% at 125°C for 72 hours.

5. The thermally conductive sheet according to any one of claims 1 to 4, wherein the thermally conductive inorganic particles comprise inorganic particles of at least one selected from the group consisting of aluminum oxide, zinc oxide, silicon oxide, silicon carbide, aluminum nitride, boron nitride, aluminum hydroxide, and silica.

6. The thermally conductive sheet according to any one of claims 1 to 5, wherein the thermally conductive sheet has a 50% compressive load value of 1000 N or less.

7. The thermally conductive sheet according to any one of claims 1 to 6, wherein the thermally conductive inorganic particles have an average particle size of 0.01 pm or more and 200 $\mu$m or less.

8. The thermally conductive sheet according to any one of claims 1 to 7, wherein the thermally conductive inorganic particles are crushed particles.

9. A method for producing the thermally conductive sheet comprising a matrix resin (A) and thermally conductive inorganic particles (B) according to any one of claims 1 to 8, the matrix resin (A) comprising an addition-curable silicone polymer (A1) and a non-reactive silicone oil (A2), the addition-curable silicone polymer (A1) accounting for 20% by mass or more and less than 100% by mass and the non-reactive silicone oil (A2) accounting for more than 0% by mass and 80% by mass or less relative to 100% by mass of the matrix resin (A), and the thermally conductive sheet comprising the thermally conductive inorganic particles (B) in an amount of 1000 to 3000 parts by mass relative to 100 parts by mass of the matrix resin (A),
the method comprising:

preparing a mixture comprising the addition-curable silicone polymer (A1), the non-reactive silicone oil (A2), and the thermally conductive inorganic particles (B);
sheeting the mixture; and
curing the sheet.

10. The method according to claim 9, wherein a cured sheet of a composition comprising the addition-curable silicone polymer (A1) and the thermally conductive inorganic particles has an oil bleeding width of 1.5 mm or less, where the composition comprises the thermally conductive inorganic particles in an amount of 1000 to 3000 parts by mass relative to 100 parts by mass of the addition-curable silicone polymer, and the oil bleeding width is a width of oil bleeding determined by sandwiching the cured sheet of 25 mm in length, 25 mm in width, and 1 mm in thickness between a glass plate and powder paper and compressing it at a compression ratio of 50% at 125°C for 72 hours.

1

3a

3b

2

3a

3b

2

FIG. 1A

2

4

5

6

FIG. 1B

11

15

12

13

14

# FIG. 2A

13

12

16

D2

D1

# FIG. 2B

## INTERNATIONAL SEARCH REPORT

| International application No. |
| --- |
| PCT/JP2021/025007 |

### A. CLASSIFICATION OF SUBJECT MATTER
H01L 23/36(2006.01)i; C08L 83/04(2006.01)i; C08K 3/01(2018.01)i
FI: H01L23/36D; C08K3/01; C08L83/04

According to International Patent Classification (IPC) or to both national classification and IPC

### B. FIELDS SEARCHED

Minimum documentation searched (classification system followed by classification symbols)
H01L23/36; C08L83/04; C08K3/01

| Documentation searched other than minimum documentation to the extent that such documents are included in the fields searched | |
| --- | --- |
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X <br> A | JP 6778846 B1 (FUJI POLYMER INDUSTRIES CO., LTD.) 04 November 2020 (2020-11-04) paragraphs [0010]-[0067], fig. 1 | 1-3, 5-9 <br> 4, 10 |
| A | WO 2020/179115 A1 (FUJI POLYMER INDUSTRIES CO., LTD.) 10 September 2020 (2020-09-10) entire text, all drawings | 1-10 |
| A | WO 2020/137086 A1 (FUJI POLYMER INDUSTRIES CO., LTD.) 02 July 2020 (2020-07-02) entire text, all drawings | 1-10 |
| A | JP 2019-65211 A (SHIN-ETSU CHEMICAL CO., LTD.) 25 April 2019 (2019-04-25) entire text, all drawings | 1-10 |

☐ Further documents are listed in the continuation of Box C.  ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 10 August 2021 (10.08.2021) | 17 August 2021 (17.08.2021) |

| Name and mailing address of the ISA/ <br> Japan Patent Office <br> 3-4-3, Kasumigaseki, Chiyoda-ku, <br> Tokyo 100-8915, Japan | Authorized officer |
| --- | --- |
| | Telephone No. |

Form PCT/ISA/210 (second sheet) (January 2015)

<table>
<tr><td colspan="2" align="center">**INTERNATIONAL SEARCH REPORT**<br>Information on patent family members</td><td colspan="2">International application No.<br><br>PCT/JP2021/025007</td></tr>
</table>

| Patent Documents referred in the Report | Publication Date | Patent Family | Publication Date |
|---|---|---|---|
| JP 6778846 B1 | 04 Nov. 2020 | (Family: none) | |
| WO 2020/179115 A1 | 10 Sep. 2020 | (Family: none) | |
| WO 2020/137086 A1 | 02 Jul. 2020 | (Family: none) | |
| JP 2019-65211 A | 25 Apr. 2019 | US 2019/0099980 A1 entire text, all drawings | |

Form PCT/ISA/210 (patent family annex) (January 2015)

**EP 4 207 270 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005344106 A
- JP 2008143980 A
- JP 2020002236 A